(19) Europäisches Patentamt
European Patent Office
Office européen des brevets

(11) EP 3 322 268 B1

(12) # EUROPEAN PATENT SPECIFICATION

(45) Date of publication and mention of the grant of the patent:
**10.08.2022 Bulletin 2022/32**

(21) Application number: **16821362.7**

(22) Date of filing: **04.07.2016**

(51) International Patent Classification (IPC):
***H05K 3/38*** (2006.01) ***C08G 73/00*** (2006.01)
***C08J 5/24*** (2006.01) ***C08K 5/541*** (2006.01)
***C08L 35/00*** (2006.01) ***C08L 101/00*** (2006.01)
***H05K 1/03*** (2006.01) ***C09D 179/08*** (2006.01)

(52) Cooperative Patent Classification (CPC):
(C-Sets available)
**C08G 73/00; C08J 5/24; C08K 5/541; C08L 35/00; C08L 101/00; C09D 179/085; H05K 1/03; H05K 3/38** (Cont.)

(86) International application number:
**PCT/JP2016/069747**

(87) International publication number:
**WO 2017/006893 (12.01.2017 Gazette 2017/02)**

(54) **METHOD FOR PRODUCING PRINTED CIRCUIT BOARD, AND RESIN COMPOSITION**

VERFAHREN ZUR HERSTELLUNG EINER LEITERPLATTE UND HARZZUSAMMENSETZUNG

MÉTHODE DE PRODUCTION D'UNE CARTE DE CIRCUIT IMPRIMÉ, ET COMPOSITION DE RÉSINE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **06.07.2015 JP 2015135203**

(43) Date of publication of application:
**16.05.2018 Bulletin 2018/20**

(73) Proprietor: **Mitsubishi Gas Chemical Company, Inc.**
**Tokyo 100-8324 (JP)**

(72) Inventors:
- **TOMIZAWA, Katsuya**
  **Tokyo 125-8601 (JP)**
- **TAKAHASHI, Hiroshi**
  **Tokyo 125-8601 (JP)**
- **SHIGA, Eisuke**
  **Tokyo 125-8601 (JP)**

(74) Representative: **Hoffmann Eitle**
**Patent- und Rechtsanwälte PartmbB**
**Arabellastraße 30**
**81925 München (DE)**

(56) References cited:
**EP-A1- 2 733 177**
**EP-A1- 3 006 503**
**WO-A1-2013/047041**
**JP-A- 2007 299 875**
**JP-A- 2008 133 414**
**JP-A- 2012 197 336**
**JP-A- 2013 189 577**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

(52) Cooperative Patent Classification (CPC): (Cont.)

C-Sets
**C09D 179/085, C08K 3/36, C08K 5/5425,**
**C08L 61/14**

## Description

### Technical Field

The present invention relates to a method for producing a printed circuit board and to a resin composition.

### Background Art

The high integration or high-density packaging of each component for semiconductor packages has been increasingly accelerated in recent years as semiconductor packages widely used in electronics, communication devices, personal computers, etc. have been more highly functionalized or miniaturized. Along with this, the difference in the coefficient of thermal expansion between a semiconductor device and a printed circuit board for semiconductor plastic packages causes the undesired warpage of semiconductor plastic packages. Various approaches against this problem have been attempted.

One example of the approaches includes reduction in thermal expansion of insulating layers for use in printed circuit boards. This approach is to suppress the warpage by bringing the coefficient of thermal expansion of a printed circuit board closer to the coefficient of thermal expansion of a semiconductor device and is currently being actively addressed (see e.g., Patent Documents 1 to 3).

In addition to the reduction in thermal expansion of printed circuit boards, increase in the rigidity of laminates (high rigidity) or increase in the glass transition temperatures of laminates (high Tg) has been studied as an approach for suppressing the warpage of semiconductor plastic packages (see e.g., Patent Documents 4 and 5).

Patent Document 6: EP 2733177 A1 describes a resin composition that is useful in an insulated layer in a printed wiring board material, comprising an inorganic filler that is soluble in an acid, a cyanic acid ester compound and an epoxy resin.

### Citation List

### Patent Document

Patent Document 1: Japanese Patent Application Laid-Open No. 2013-216884
Patent Document 2: Japanese Patent No. 3173332
Patent Document 3: Japanese Patent Application Laid-Open No. 2009-035728
Patent Document 4: Japanese Patent Application Laid-Open No. 2013-001807
Patent Document 5: Japanese Patent Application Laid-Open No. 2011-178992

### Summary of Invention

### Technical Problem

As in Patent Document 4 described above, by causing an inorganic filler to be contained in a resin composition to lessen thermal expansion, it is possible to reduce warpage of a semiconductor package when the semiconductor package is produced compared with the case where no inorganic filler is contained. However, an attempt to form an insulating layer of a printed circuit board using such a resin composition may result in a poor adhesion between the insulating layer and the conductor layer that constitute the printed circuit board. Accordingly, a technique is desired for maintaining an enhanced adhesion between the insulating layer and the conductor layer of a printed circuit board even when the insulating layer contains an inorganic filler.

The present invention has been made in light of these circumstances, and an object of the present invention is to provide a method for producing a printed circuit board capable of enhancing the adhesion between the insulating layer containing an inorganic filler and the conductor layer of a printed circuit board, and a resin composition.

### Solution to Problem

The present inventors have conducted diligent studies to achieve the object and consequently found that, in producing a printed circuit board, a specific treatment performed on the insulating layer results in an enhanced adhesion between the treated insulating layer and the conductor layer. On the basis of the finding, the present invention has been completed.

Specifically, the present invention is as described in the claims.

Advantageous Effects of Invention

According to the present invention, it is possible to provide a method for producing a printed circuit board capable of enhancing the adhesion between the insulating layer containing an inorganic filler and the conductor layer of a printed circuit board, and a resin composition. Description of Embodiments

Hereinafter, an embodiment for carrying out the present invention (hereinafter, also referred to as the "present embodiment") will be described in detail. However, the present invention is not intended to be limited by the present embodiment described below. Various changes or modifications may be made in the present invention without departing from the spirit of the present invention.

The method for producing a printed circuit board of the present embodiment has an alkali treatment step of bringing the surface of an insulating layer for a printed circuit board into contact with an aqueous alkali solution; and a conductor layer forming step of forming a conductor layer on at least a part of the surface of the insulating layer that has undergone the alkali treatment step.

In the alkali treatment step, the surface of the insulating layer for a printed circuit board is brought into contact with an aqueous alkali solution. The alkali treatment step is not particularly limited as long as it is the step of bringing the surface of the insulating layer into contact with an aqueous alkali solution prior to the conductor layer forming step, and the contact treatment may also serve as desmear treatment as performed in a conventional production process of a printed circuit board, or may be a treatment that does not serve as desmear treatment, i.e., may be included in the production method of the present embodiment separately from desmear treatment. Among these, in view of more effectively and reliably exhibiting both the effect of removing smear in desmear treatment and the effect of improving the adhesion between the insulating layer and the conductor layer in the alkali treatment step in the case of performing desmear treatment, the method for producing a printed circuit board of the present embodiment preferably has an alkali treatment step that is separate from the step of performing desmear treatment.

The insulating layer contains a resin composition containing a thermosetting resin, a silane compound having a (meth)acrylic skeleton (an acrylic skeleton or a methacrylic skeleton) and a hydrolyzable group or a hydroxy group (hereinafter, referred to as an "acrylic silane compound"), and an inorganic filler. In the present embodiment, when the resin composition contains an acrylic silane compound, the acrylic silane compound that is present in the vicinity of the insulating layer surface and plays the role of bonding the inorganic filler to and retaining it on the insulating layer surface is hydrolyzed in the alkali treatment step, thus the inorganic filler exposed to the insulating layer surface peels off and, as a result, the amount of the inorganic filler present on the insulating layer surface decreases. The inorganic filler reduces the adhesion between the insulating layer and the conductor layer formed on the surface of the insulating layer during the subsequent conductor layer forming step. However, in the present embodiment, since the amount of the inorganic filler present on the insulating layer surface is reduced through the alkali treatment step as described above, the adhesion between the conductor layer and the insulating layer can be enhanced. In addition, it is considered that traces of places where the filler has peeled off on the insulating layer surface are utilized as an anchor for the conductor layer during conductor layer formation, thus contributing to a further improvement of adhesion.

The thermosetting resin is not particularly limited. Examples include a maleimide compound, an alkenyl-substituted nadimide, a cyanate ester compound, an epoxy resin, a phenol resin, benzoxazine, a BT resin (a bismaleimide-triazine resin), an amine compound, and a vinyl compound. Among these, a maleimide compound is preferred in view of enhancing adhesion (bonding properties) to the inorganic filler and increasing the glass transition temperature of the insulating layer (especially in combination with an alkenyl-substituted nadimide), an alkenyl-substituted nadimide is preferred in view of increasing the glass transition temperature of the insulating layer (especially in combination with a maleimide compound), and a cyanate ester compound is preferred in view of moldability and adhesion between the insulating layer and the conductor layer. These thermosetting resins are used singly or in combinations of two or more thereof.

The resin composition according to the present embodiment preferably contains a maleimide compound as a thermosetting resin. The maleimide compound is not particularly limited as long as the compound has one or more maleimide groups in the molecule. Specific examples thereof include N-phenylmaleimide, N-hydroxyphenylmaleimide, bis(4-maleimidophenyl)methane, 2,2-bis{4-(4-maleimidophenoxy)-phenyl}propane, bis(3,5-dimethyl-4-maleimidophenyl)methane, bis(3-ethyl-5-methyl-4-maleimidophenyl)methane, bis(3,5-diethyl-4-maleimidophenyl)methane, a maleimide compound represented by the formula (6) set forth below, prepolymers of these maleimide compounds, and prepolymers of the maleimide compounds and amine compounds. These compounds can be used singly or in a form of a suitable mixture of two or more thereof.

Among them, bis(4-maleimidophenyl)methane, 2,2-bis{4-(4-maleimidophenoxy)-phenyl}propane, bis(3-ethyl-5-methyl-4-maleimidophenyl)methane, or a maleimide compound represented by the following formula (6) is preferred, and a maleimide compound represented by the following formula (6) is particularly preferred. When the resin composition contains such a maleimide compound, the coefficient of thermal expansion of a cured product is more reduced, and a printed circuit board can be obtained which has an even better heat resistance and glass transition temperature.

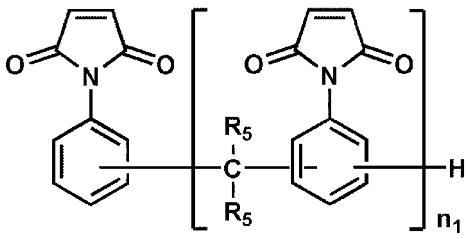
(6)

In the formula (6), each $R_5$ independently represents a hydrogen atom or a methyl group and is particularly preferably a hydrogen atom. In the formula, $n_1$ represents an integer of 1 or larger. The upper limit of $n_1$ is preferably 10, more preferably 7.

When the resin composition of the present embodiment contains a maleimide compound, the content of the maleimide compound may be determined according to the ratio of the number of functional group between the number of alkenyl groups ($\alpha$) as a functional group in an optionally contained alkenyl-substituted nadimide and the number of maleimide groups ($\beta$) in the maleimide compound ([$\beta/\alpha$]) as mentioned later. The content of the maleimide compound is preferably 15 to 70 parts by mass, more preferably 20 to 45 parts by mass, based on 100 parts by mass in total of component(s) constituting a resin (also including components that form resins by polymerization; the same holds true for the description below) in the resin composition. When the content of the maleimide compound falls within such a range, a printed circuit board can be obtained which is excellent in moldability even when filled with an inorganic filler, and excellent in curability, elastic modulus under heat, desmear resistance, and chemical resistance.

The resin composition according to the present embodiment preferably contains an alkenyl-substituted nadimide as a thermosetting resin. The alkenyl-substituted nadimide is not particularly limited as long as the compound has one or more alkenyl-substituted nadimide groups in the molecule. Specific examples thereof include a compound represented by the following formula (1):

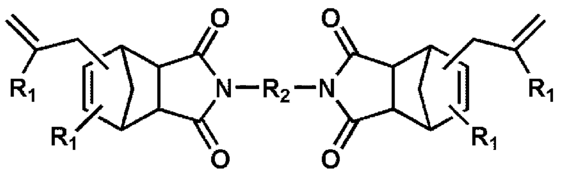
(1)

In the formula (1), each $R_1$ independently represents a hydrogen atom or an alkyl group having 1 to 6 carbon atoms, and $R_2$ represents an alkylene group having 1 to 6 carbon atoms, a phenylene group, a biphenylene group, a naphthylene group, or a group represented by the following formula (2) or (3):

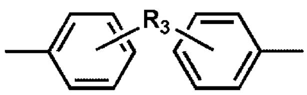
(2)

In the formula (2), $R_3$ represents a methylene group, an isopropylidene group, or a substituent represented by CO, O, S, or $SO_2$.

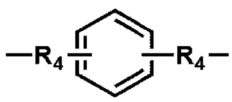
(3)

In the formula (3), each $R_4$ is independently selected and represents an alkylene group having 1 to 4 carbon atoms, or a cycloalkylene group having 5 to 8 carbon atoms.

A commercially available product can also be used as the alkenyl-substituted nadimide represented by the formula (1). Examples of the commercially available product include, but are not particularly limited to, a compound represented by the formula (4) set forth below (BANI-M (manufactured by Maruzen Petrochemical Co., Ltd.)), and a compound represented by the formula (5) set forth below (BANI-X (manufactured by Maruzen Petrochemical Co., Ltd.)). These compounds may be used singly or in combinations of two or more thereof.

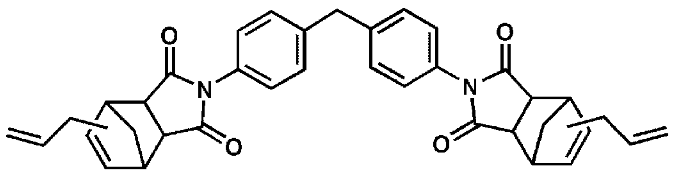

(4)

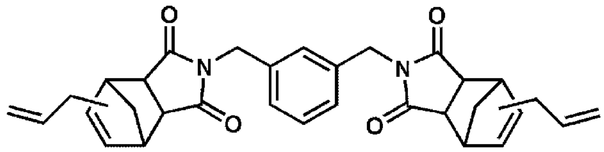

(5)

When the resin composition of the present embodiment contains an alkenyl-substituted nadimide, the content of the alkenyl-substituted nadimide may be determined according to the ratio of the number of functional group between an alkenyl group, one of its functional groups, and a maleimide group in an optionally contained maleimide compound as mentioned later. The content of the alkenyl-substituted nadimide is preferably 20 to 50 parts by mass, more preferably 25 to 45 parts by mass, based on 100 parts by mass in total of component(s) constituting a resin in the resin composition. When the content of the alkenyl-substituted nadimide falls within such a range, a printed circuit board can be obtained which is excellent in moldability even when filled with an inorganic filler, and excellent in curability, elastic modulus under heat, desmear resistance, and chemical resistance.

When the resin composition of the present embodiment contains both an alkenyl-substituted nadimide and a maleimide compound, the contents thereof may be defined according to the ratio between the numbers of their respective designated functional groups. In this context, the designated functional group of the alkenyl-substituted nadimide is alkenyl groups bonded to molecular ends, and the designated functional group of the maleimide compound is maleimide groups.

The resin composition of the present embodiment preferably contains the alkenyl-substituted nadimide and the maleimide compound so as to satisfy a relationship represented by the following formula (E), more preferably a relationship represented by the following formula (E1):

$$0.9 \leq \beta/\alpha \leq 4.3 \quad (E)$$

$$1.5 \leq \beta/\alpha \leq 4.0 \quad (E1)$$

In these formulas, $\alpha$ represents the total number of alkenyl groups contained in the alkenyl-substituted nadimide in the resin composition, and $\beta$ represents the total number of maleimide groups contained in the maleimide compound in the resin composition. When the ratio between the numbers of functional groups ($\beta/\alpha$) falls within such a range, a printed circuit board can be obtained which has even better low thermal expansion, elastic modulus under heat, heat resistance, heat resistance after moisture absorption, desmear resistance, chemical resistance, and curability.

The resin composition according to the present embodiment preferably contains a cyanate ester compound as a thermosetting resin. Examples of the type of the cyanate ester compound include, but are not particularly limited to, a naphthol aralkyl-based cyanate ester represented by the formula (7) set forth below, a novolac-based cyanate ester represented by the formula (8) set forth below, biphenyl aralkyl-based cyanate esters, bis(3,3-dimethyl-4-cyanatophenyl)methane, bis(4-cyanatophenyl)methane, 1,3-dicyanatobenzene, 1,4-dicyanatobenzene, 1,3,5-tricyanatobenzene, 1,3-dicyanatonaphthalene, 1,4-dicyanatonaphthalene, 1,6-dicyanatonaphthalene, 1,8-dicyanatonaphthalene, 2,6-dicyanatonaphthalene, 2,7-dicyanatonaphthalene, 1,3,6-tricyanatonaphthalene, 4,4'-dicyanatobiphenyl, bis(4-cyanatophenyl) ether, bis(4-cyanatophenyl) thioether, bis(4-cyanatophenyl)sulfone, and 2,2-bis(4-cyanatophenyl)propane.

Among them, a naphthol aralkyl-based cyanate ester represented by the following formula (7), a novolac-based cyanate ester represented by the following formula (8), and a biphenyl aralkyl-based cyanate ester are particularly preferred because of excellent flame retardancy, high curability, and the low coefficient of thermal expansion of a cured product.

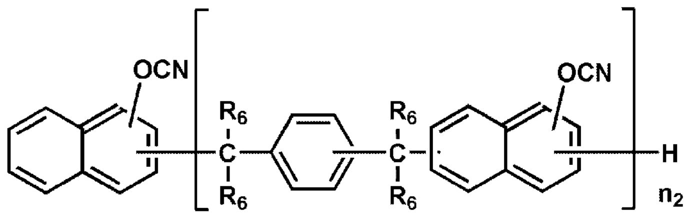

(7)

In this formula, each $R_6$ independently represents a hydrogen atom or a methyl group and is particularly preferably a hydrogen atom. In the formula, $n_2$ represents an integer of 1 or larger. The upper limit of $n_2$ is preferably 10, more preferably 6.

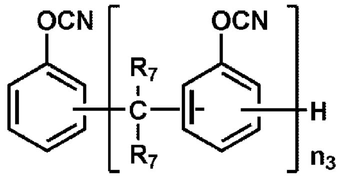

(8)

In this formula, each $R_7$ independently represents a hydrogen atom or a methyl group and is particularly preferably a hydrogen atom. In the formula, $n_3$ represents an integer of 1 or larger. The upper limit of $n_3$ is preferably 10, more preferably 7.

Methods for producing these cyanate ester compounds are not particularly limited, and the cyanate ester compound used in the present embodiment may be produced by any method existing as a cyanate ester synthesis method. As a specific example, the cyanate ester compound can be obtained by reacting a naphthol aralkyl-based phenol resin represented by the formula (9) set forth below with cyanogen halide in the presence of a basic compound in an inert organic solvent. An alternate method that may be adopted involves forming a salt of a similar naphthol aralkyl-based phenol resin and a basic compound in a solution containing water, followed by two-phase interfacial reaction with cyanogen halide for synthesis.

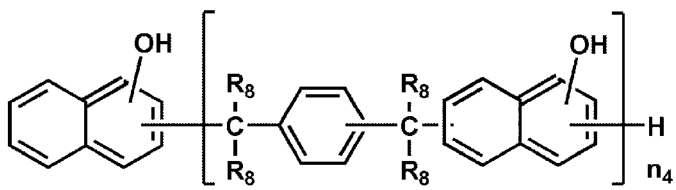

(9)

In this formula, each $R_8$ independently represents a hydrogen atom or a methyl group and is particularly preferably a hydrogen atom. In the formula, $n_4$ represents an integer of 1 or larger. The upper limit of $n_4$ is preferably 10, more preferably 6.

The naphthol aralkyl-based cyanate ester can be selected from those obtained by condensing cyanic acid with a naphthol aralkyl resin obtained through the reaction of a naphthol such as α-naphthol or β-naphthol with p-xylylene glycol, a,a'-dimethoxy-p-xylene, 1,4-di(2-hydroxy-2-propyl)benzene, or the like.

When the resin composition of the present embodiment contains a cyanate ester compound, the content of the cyanate ester compound is not particularly limited and is preferably 0.01 to 40 parts by mass, more preferably 0.01 to 25 parts by mass, based on 100 parts by mass in total of component(s) constituting a resin in the resin composition. When the content of the cyanate ester compound falls within such a range, an insulating layer for a printed circuit board can be obtained which has even better moldability when filled with an inorganic filler, and yet has even better elastic modulus under heat, desmear resistance, and chemical resistance.

The resin composition according to the present embodiment may be supplemented with a resin other than those mentioned above (hereinafter, referred to as an "additional resin") without impairing the expected characteristics. The type of the additional resin is not particularly limited as long as the resin has insulating properties. Examples thereof include resins such as thermoplastic resins and silicone resins. Appropriately combined use with these resins can impart characteristics such as metal adhesion and stress-relaxing properties.

The resin composition according to the present embodiment contains an acrylic silane compound. The acrylic silane compound is not particularly limited as long as it has a (meth)acrylic skeleton and a hydrolyzable group or a

hydroxy group. The acrylic silane compound may be any compound for use as a silane coupling agent having a (meth)acrylic skeleton and a hydrolyzable group or a hydroxy group (so-called acrylic silane coupling agent). The acrylic silane compound preferably includes a compound represented by the following formula (C), in view of more effectively and reliably exhibiting the function effects of the present invention.

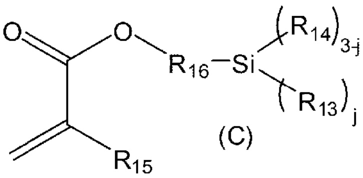

(C)

In the formula (C), $R_{13}$ represents a hydrolyzable group or a hydroxy group; $R_{14}$ represents a hydrogen atom or an alkyl group having 1 to 3 carbon atoms; when a plurality of $R_{13}$ or $R_{14}$ are present, the plurality of $R_{13}$ or $R_{14}$ are the same as or different from each other; $R_{15}$ represents a hydrogen atom or a methyl group; $R_{16}$ represents an alkylene group having 2 to 10 carbon atoms; and j represents an integer of 1 to 3. Also, examples of the hydrolyzable group include: alkoxy groups such as a methoxy group, an ethoxy group, and a propoxy group; and halogen atoms such as a chlorine atom and an iodine atom (the same holds true for the description below). $R_{16}$ is preferably an alkylene groups having 2 to 8 carbon atoms, and more preferably an alkylene group having 2 to 5 carbon atoms.

Specific examples of the acrylic silane compound include 3-methacryloxypropylmethyldimethoxysilane, 3-methacryloxypropyltrimethoxysilane, 3-methacryloxypropylmethyldiethoxysilane, 3-methacryloxypropyltriethoxysilane, 3-acryloxypropyltrimethoxysilane, and methacryloxyoctyltrimethoxysilane. Among these, 3-acryloxypropyltrimethoxysilane is preferred. Examples of commercially available products include KBM-502, KBM-503, KBE-502, KBE-503, KBM-5103, and KBM-5803 (above are the names of products manufactured by Shin-Etsu Chemical Co., Ltd.). These acrylic silane compounds are used singly or in combinations of two or more thereof.

In the resin composition of the present embodiment, the content of the acrylic silane compound is not particularly limited and is preferably 0.1 to 15 parts by mass, more preferably 0.5 to 5 parts by mass, based on 100 parts by mass in total of component(s) constituting a resin in the resin composition. The content of the acrylic silane compound within the range described above further enhances the adhesion between the insulating layer and the conductor layer and, also, leads to further improvement in heat resistance after moisture absorption and moldability.

The resin composition according to the present embodiment contains an inorganic filler. The inorganic filler contributes to reduction in the thermal expansion of a printed circuit board and improvement in elastic modulus and the coefficient of thermal conductivity. The inorganic filler is not particularly limited as long as the inorganic filler has insulating properties. Examples thereof include silicas (e.g., natural silica, fused silica, amorphous silica, and hollow silica), alumina, aluminum nitride, boron nitride, boehmite, molybdenum oxide, titanium oxide, silicone rubber, hybrid silicone powder, zinc borate, zinc stannate, clay, kaolin, talc, fired clay, fired kaolin, fired talc, mica, short glass fiber (fine glass powders such as E glass and D glass), hollow glass, and spherical glass. These inorganic fillers are used singly or in combinations of two or more thereof. Among them, silica is preferred in view of low thermal expansion; alumina and aluminum nitride are preferred in view of high thermal conductivity, and alumina is more preferable; and boehmite is preferred in view of processability. The inorganic filler may be surface-treated in advance with the acrylic silane compound. A method for the surface treatment is not particularly limited. Examples thereof include direct treatment methods such as a dry treatment method and a treatment method using slurry (wet method). A wet method is preferred in view of uniform treatment. Alternatively, the inorganic filler may be a commercially available surface-treated inorganic filler.

In the resin composition according to the present embodiment, the content of the inorganic filler is not particularly limited and is preferably 100 to 1100 parts by mass, more preferably 100 to 700 parts by mass, based on 100 parts by mass in total of component(s) constituting a resin in the resin composition. When the content of the inorganic filler falls within the range described above, characteristics unique to the inorganic filler, such as low thermal expansion, high elasticity, and the coefficient of thermal conductivity are exhibited, while reduction in moldability can be further suppressed.

The average particle size (D50) of the inorganic filler is not particularly limited and is preferably 0.2 to 10 μm, more preferably 0.2 to 5 μm, because finer wiring can be formed thereby. The particle shape of the inorganic filler is not particularly limited and is preferably a spherical or substantially spherical shape in view of moldability. In this context, D50 is a median size and is a size that splits the measured particle size distribution of a powder such that the mass of half of the particles being larger is equal to the mass of half of the particles being smaller. D50 is generally measured by a wet laser diffraction/scattering method.

The resin composition according to the present embodiment may contain a silane compound having a group capable of being chemically bonded to an organic group, and a hydrolyzable group or a hydroxy group (hereinafter, referred to as an "additional silane compound"), except for the above acrylic silane compound, and/or a wetting dispersant in order to improve the dispersibility of the inorganic filler and the adhesion between the thermosetting resin and the

inorganic filler or glass cloth. The additional silane compound is not particularly limited and may be a silane coupling agent generally used in the surface treatment of inorganic substance. Specific examples of the additional silane compound include: styryl silane compounds; epoxysilane compounds; aminosilane compounds having an amino group and a hydrolyzable group or a hydroxy group, such as 3-aminopropyltriethoxysilane and N-β-(aminoethyl)-3-aminopropyltrimethoxysilane; vinylsilane compounds having a vinyl group and a hydrolyzable group or a hydroxy group, such as 3-vinyltrimethoxysilane. Among these, a styryl silane compound is preferred in view of further enhancing the adhesion between the thermosetting resin and the inorganic filler, and an epoxysilane compound is preferred in view of the dispersibility of the inorganic filler and moldability. These additional silane compounds are used singly or in combinations of two or more thereof.

The styryl silane compound is not particularly limited as long as the styryl silane compound is a silane compound having a styrene skeleton and a hydrolyzable group or a hydroxy group. The styryl silane compound may be any compound for use as a silane coupling agent having a styrene skeleton and a hydrolyzable group or a hydroxy group (so-called styryl silane coupling agent). The styryl silane compound preferably includes a compound represented by the following formula (A).

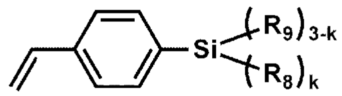

(A)

In the formula (A), $R_8$ represents the hydrolyzable group or the hydroxy group; $R_9$ represents a hydrogen atom or an alkyl group having 1 to 3 carbon atoms; when a plurality of $R_8$ or Rg are present, the plurality of $R_8$ or $R_9$ are the same as or different from each other; and k represents an integer of 1 to 3.

Specific examples of the styryl silane compound include p-styryltrimethoxysilane, p-styryltriethoxysilane, p-styrylmethyldimethoxysilane, p-styrylmethyldiethoxysilane, and N-(vinylbenzyl)-2-aminoethyl-3-aminopropyltrimethoxysilane hydrochloride. Among them, p-styryltrimethoxysilane or p-styryltriethoxysilane is preferred, and p-styryltrimethoxysilane is more preferred. Examples of commercially available products include KBM-575 and KBM-1403 (both are the names of products manufactured by Shin-Etsu Chemical Co., Ltd.). These styryl silane compounds are used singly or in combinations of two or more thereof.

The resin composition according to the present embodiment preferably contains an epoxysilane compound in order to enhance the dispersibility of the inorganic filler and provide excellent moldability. The epoxysilane compound is not particularly limited as long as the epoxysilane compound is a silane compound having an epoxy skeleton and a hydrolyzable group or a hydroxy group. The epoxysilane compound may be any compound for use as a silane coupling agent having an epoxy group and a hydrolyzable group or a hydroxy group (so-called epoxysilane coupling agent). The epoxysilane compound preferably includes a compound represented by the following formula (D), in view of more effectively and reliably exhibiting the function effects of the present invention.

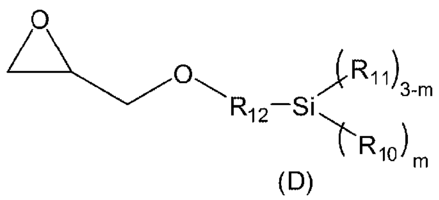

(D)

In the formula (D), $R_{10}$ represents a hydrolyzable group or a hydroxy group; $R_{11}$ represents a hydrogen atom or an alkyl group having 1 to 3 carbon atoms; when a plurality of $R_{10}$ or $R_{11}$ are present, the plurality of $R_{10}$ or $R_{11}$ are the same as or different from each other; $R_{12}$ represents an alkylene group having 1 to 10 carbon atoms; and m represents an integer of 1 to 3. $R_{12}$ is preferably an alkylene group having 1 to 8 carbon atoms, more preferably an alkylene group having 1 to 6 carbon atoms, and even more preferably an alkylene group having 1 to 4 carbon atoms.

Specific examples of the epoxysilane compound include 3-glycidoxypropyltrimethoxysilane, 3-glycidoxypropylmethyldimethoxysilane, 3-glycidoxypropyltriethoxysilane, 3-glycidoxypropylmethyldiethoxysilane, and 3-glycidoxypropyltriethoxysilane. Among these, 3-glycidoxypropyltrimethoxysilane is preferred. Examples of commercially available products include KBM-403, KBM-402, KBE-403, and KBE-402 (above are the names of products manufactured by Shin-Etsu Chemical Co., Ltd.). These epoxysilane compounds are used singly or in combinations of two or more thereof.

In the resin composition of the present embodiment, the content of the additional silane compound is not particularly limited and is preferably 0.1 to 15 parts by mass, more preferably 0.5 to 3 parts by mass, based on 100 parts by mass in total of component(s) constituting a resin in the resin composition. The content of the additional silane

compound within the range described above leads to further improvement in the dispersibility of the inorganic filler, while it does not inhibit the hydrolytic peeling of the acrylic silane compound by alkali treatment and thus peel strength can be improved.

The resin composition according to the present embodiment may contain a wetting dispersant in view of enhancing the dispersibility of the inorganic filler. The wetting dispersant is not particularly limited as long as the wetting dispersant is used as a dispersion stabilizer for paint. Examples of commercially available products of the wetting dispersant include Disperbyk-110, 111, 118, 180, 161, 2009, BYK-W996, W9010, and W903 (all are product names) manufactured by BYK Japan K.K. These wetting dispersants are used singly or in combinations of two or more thereof.

The resin composition of the present embodiment may be used in combination with a curing accelerator without impairing expected characteristics. Examples of the curing accelerator include: imidazole compounds; organic peroxides such as benzoyl peroxide, lauroyl peroxide, acetyl peroxide, p-chlorobenzoyl peroxide, and di-tert-butyl-di-perphthalate; azo compounds such as azobisnitrile; tertiary amines such as N,N-dimethylbenzylamine, N,N-dimethylaniline, N,N-dimethyltoluidine, 2-N-ethylanilinoethanol, tri-n-butylamine, pyridine, quinoline, N-methylmorpholine, triethanolamine, triethylenediamine, tetramethylbutanediamine, and N-methylpiperidine; phenols such as phenol, xylenol, cresol, resorcin, and catechol; organic metal salts such as lead naphthenate, lead stearate, zinc naphthenate, zinc octoate, tin oleate, dibutyl tin maleate, manganese naphthenate, cobalt naphthenate, and acetyl acetone iron; these organic metal salts dissolved in hydroxy group-containing compounds such as phenol and bisphenol; inorganic metal salts such as tin chloride, zinc chloride, and aluminum chloride; and dioctyl tin oxide and other organic tin compounds such as alkyl tin and alkyl tin oxide. These curing accelerators are used singly or in combinations of two or more thereof.

The resin composition of the present embodiment preferably further contains an imidazole compound among the curing accelerators described above. The imidazole compound is not particularly limited and is preferably an imidazole compound represented by the following formula (11) in view of more effectively and reliably exhibiting the function effects of the present invention.

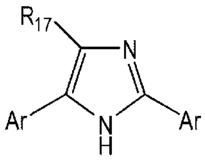

(11)

In this formula, Ar represents a phenyl group, a naphthalene group, a biphenyl group, or an anthracene group, or a monovalent group thereof modified with a hydroxy group, and $R_{17}$ represents a hydrogen atom, an alkyl group or a monovalent group thereof modified with a hydroxy group, or an aryl group. Examples of the aryl group include a substituted or unsubstituted phenyl group, naphthalene group, biphenyl group, and anthracene group.

Examples of the imidazole compound include 2-methylimidazole, 2-ethyl-4-methylimidazole, 2-phenylimidazole, 1-cyanoethyl-2-phenylimidazole, 1-cyanoethyl-2-ethyl-4-methylimidazole, 2-phenyl-4,5-dihydroxymethylimidazole, 2-phenyl-4-methyl-5-hydroxymethylimidazole, and 2,4,5-triphenylimidazole. Among these, 2,4,5-triphenylimidazole is preferred.

In the resin composition according to the present embodiment, the content of the imidazole compound is not particularly limited and is preferably 0.01 to 10 parts by mass, more preferably 0.1 to 5 parts by mass, based on 100 parts by mass in total of component(s) constituting a resin in the resin composition. When the content of the imidazole compound falls within such a range, a printed circuit board can be obtained that is excellent in curability and moldability.

The resin composition according to the present embodiment may further contain a surface conditioner for the purpose of, for example, improving the dispersibility of solid material such as the inorganic filler. The surface conditioner is not particularly limited as long as the surface conditioner is a surfactant conventionally contained in resin compositions. Examples thereof include polydimethylsiloxane derivatives and acrylic derivatives. Examples of commercially available products thereof include BYK-310, 330, and 346 manufactured by BYK Japan K.K. These surface conditioners are used singly or in combinations of two or more thereof.

The resin composition according to the present embodiment may also contain a solvent, if necessary. For example, use of an organic solvent reduces viscosity during the preparation of the resin composition and thus improves handleability while enhancing the impregnation of glass cloth with the resin composition. The type of the solvent is not particularly limited as long as the solvent is capable of dissolving a portion or the whole of the resins in the resin composition. Specific examples thereof include, but are not particularly limited to: ketones such as acetone, methyl ethyl ketone, and methylcellosolve; aromatic hydrocarbons such as toluene and xylene; amides such as dimethylformamide; and propylene glycol monomethyl ether and its acetate. These solvents are used singly or in combinations of two or more thereof.

The resin composition according to the present embodiment can be prepared in accordance with an ordinary

method. For example, a preferred method involves obtaining a resin composition homogeneously containing the components mentioned above. Specifically, for example, the components mentioned above can be sequentially added to the solvent and sufficiently stirred to readily prepare the resin composition of the present embodiment. The acrylic silane compound and the additional silane compound may be directly contained in the resin composition, as with other components. Alternatively or additionally to this, the inorganic filler may be surface-treated with the acrylic silane compound and the additional silane compound, and the inorganic filler bonded at its surface to these silane compounds can then be mixed with other components to prepare the resin composition. Among these, it is more preferred that the acrylic silane compound and the additional silane compound are directly contained in the resin composition as with other components than that the inorganic filler is surface-treated with the acrylic silane compound and the additional silane compound, and the inorganic filler bonded at its surface to these silane compounds is mixed with other components, because the adhesion between the insulating layer and the conductor layer tends to be more enhanced. The method for surface-treating the inorganic filler with the acrylic silane compound and the additional silane compound is not particularly limited. Examples thereof include direct treatment methods such as a dry treatment method and a treatment method using slurry (wet method). A wet method is preferred in view of uniform treatment. Alternatively, a commercially available surface-treated inorganic filler (filler) may be used.

An organic solvent may be used, if necessary, in the preparation of the resin composition of the present embodiment. The type of the organic solvent is not particularly limited as long as the solvent is capable of dissolving the resins in the resin composition. Specific examples thereof are as listed above. Treatment (stirring, mixing, or kneading treatment, etc.) known in the art for uniformly dissolving or dispersing each component can be carried out in the preparation of the resin composition. In the case of using, for example, the inorganic filler, the inorganic filler can be uniformly dispersed by stirring and dispersion treatment using a stirring vessel equipped with a stirrer having an appropriate stirring ability. This enhances the dispersibility of the inorganic filler in the resin composition. The stirring, mixing, or kneading treatment can be appropriately performed by using an apparatus known in the art such as an apparatus aimed at mixing, such as a ball mill or a bead mill, or a revolution- or rotation-type mixing apparatus.

The insulating layer is formed of a resin composition layer (a layer composed of the resin composition described above) in a prepreg, a resin sheet, a laminate, and a metal foil-clad laminate, and these are preferred.

The prepreg according to the present embodiment includes a base material and the resin composition, the base material being impregnated or coated with the resin composition. Such a prepreg is obtained by impregnating or coating a base material with the resin composition. The method for producing the prepreg can be carried out in accordance with an ordinary method without particular limitations. For example, the base material can be impregnated or coated with the resin components according to the present embodiment, followed by semi-curing (conversion to B-staging) by heating or the like for 1 to 30 minutes in a drier of 100 to 200°C to prepare the prepreg of the present embodiment.

The content of the resin composition (containing the inorganic filler) is not particularly limited and is preferably 30 to 90% by mass, more preferably 35 to 85% by mass, further preferably 40 to 80% by mass, based on the total mass of the prepreg. When the content of the resin composition falls within the range described above, moldability tends to be further improved.

The base material is not particularly limited and can be appropriately selected for use from various printed circuit board materials known in the art according to the intended use or performance. Specific examples thereof include, but are not particularly limited to: glass fibers such as E glass, D glass, S glass, Q glass, spherical glass, NE glass, L glass, and T glass; non-glass inorganic fibers such as quartz; wholly aromatic polyamides such as poly-p-phenyleneterephthalamide (Kevlar(R), manufactured by Du Pont K.K.) and co-poly-p-phenylene/3,4'-oxydiphenylene/terephthalamide (Technora(R), manufactured by Teijin Techno Products, Ltd.); polyesters such as 2,6-hydroxynaphthoic acid/p-hydroxybenzoic acid (Vectran(R), manufactured by Kuraray Co., Ltd.) and Zexion(R) (manufactured by KB Seiren, Ltd.); and organic fibers such as poly-p-phenylene benzoxazole (Zylon(R), manufactured by Toyobo Co., Ltd.) and polyimide. Among them, E glass, T glass, S glass, Q glass, or an organic fiber is preferred in view of a low coefficient of thermal expansion. These base materials may be used singly or in combinations of two or more thereof.

Examples of the form of the base material include, but are not particularly limited to, woven fabrics, nonwoven fabrics, lobings, chopped strand mats, and surfacing mats. The textures of the woven fabrics are not particularly limited, and, for example, plain weave, mat weave, and twill weave are known. The base material can be appropriately selected for use from these materials known in the art according to the intended use or performance. Such a base material subjected to opening treatment or a glass woven fabric surface-treated with a silane compound (e.g., a silane coupling agent) or the like is preferably used. The base material is not particularly limited by its thickness and mass. Usually, the thickness of the base material of approximately 0.01 to 0.3 mm is preferably used. In particular, the base material is preferably a glass woven fabric having a thickness of 200 $\mu$m or smaller and a mass of 250 g/m$^2$ or smaller, more preferably a woven fabric (cloth) made of one or more fibers selected from the group consisting of E glass, S glass, T glass and Q glass fibers, and an organic fiber in view of strength and water absorbability.

The resin sheet according to the present embodiment includes a support (sheet base material) and the resin composition, the sheet base material being coated with the resin composition. The resin composition is laminated on

one side or both sides of the sheet base material. The resin sheet is used as an approach for thinning and can be produced, for example, by directly coating a support such as a metal foil or a film with a thermosetting resin (containing an inorganic filler) for use in prepregs, etc., followed by drying.

The sheet base material is not particularly limited, and any of various printed circuit board materials known in the art can be used. Examples thereof include polyimide films, polyamide films, polyester films, polyethylene terephthalate (PET) films, polybutylene terephthalate (PBT) films, polypropylene (PP) films, polyethylene (PE) films, aluminum foils, copper foils, and gold foils. Among them, an electrolytic copper foil or a PET film is preferred.

Examples of the coating method include a method of applying a solution of the resin composition of the present embodiment dissolved in a solvent onto the sheet base material using a bar coater, a die coater, a doctor blade, a Baker applicator, or the like.

The resin sheet is preferably a product obtained by coating the support (sheet base material) with the resin composition, followed by semi-curing (conversion to B-staging) the resin composition. Specific examples thereof include a method which involves coating the sheet base material such as a copper foil with the resin composition, followed by semi-curing the resin composition by a method such as heating for 1 to 60 minutes in a drier of 100 to 200°C to produce the resin sheet. The amount of the resin composition applied to the support is preferably in the range of 1 to 300 μm in terms of the resin thickness of the resin sheet. The resin sheet of the present embodiment can be used as a buildup material for printed circuit boards.

The laminate according to the present embodiment has one or more layers of at least one material selected from the group consisting of the aforementioned prepreg and resin sheet and includes a cured product of the resin composition contained in at least one material selected from the group consisting of the aforementioned prepreg and resin sheet. This laminate can be obtained by curing one or more layers of at least one material selected from the group consisting of the aforementioned prepreg and resin sheet. When providing layers of a prepreg or a resin sheet, for example, a vacuum laminating method can be used. The metal foil-clad laminate according to the present embodiment is a metal foil-clad laminate having at least one material selected from the group consisting of the aforementioned prepreg and resin sheet, and a metal foil disposed on one side or both sides of at least one material selected from the group consisting of the aforementioned prepreg and resin sheet, the metal foil-clad laminate including a cured product of the resin composition contained in at least one material selected from the group consisting of the aforementioned prepreg and resin sheet. This metal foil-clad laminate can be obtained by providing one or more layers of at least one material selected from the group consisting of the aforementioned prepreg and resin sheet, and disposing the metal foil on one side or both sides thereof, followed by laminate molding. More specifically, the metal foil-clad laminate can be produced by laminating one or more layers of the aforementioned prepreg and/or resin sheet, disposing the metal (e.g., copper or aluminum) foil on one side or both sides thereof if desired, and carried out laminate molding of this structure according to the need. In this context, the metal foil used is not particularly limited as long as the metal foil can be used as a printed circuit board material. A copper foil known in the art such as a rolled copper foil or an electrolytic copper foil is preferred. The thickness of the metal foil is not particularly limited and is preferably 1 to 70 μm, more preferably 1.5 to 35 μm. The metal foil-clad laminate is not particularly limited by its molding method and molding conditions and can be molded by use of a general approach and conditions for laminates for printed circuit boards and multilayer boards. For example, a multiplaten press, a multiplaten vacuum press, a continuous molding machine, or an autoclave molding machine can be used in the molding of the metal foil-clad laminate. The metal foil-clad laminate is generally molded at a temperature of 100 to 300°C and a pressure of 2 to 100 $kgf/cm^2$ in terms of surface pressure for a heating time in the range of 0.05 to 5 hours. If necessary, post curing may be further carried out at a temperature of 150 to 300°C. Alternatively, the laminate molding of the prepreg mentioned above may be carried out in combination with a separately prepared wiring board for an inner layer to obtain a multilayer board.

As already described, the alkali treatment step is not particularly limited as long as it is the step of bringing the surface of the insulating layer into contact with an aqueous alkali solution prior to the conductor layer forming step, and the contact treatment may also serve as desmear treatment as performed in a conventional production process of a printed circuit board, or may be a treatment that does not serve as desmear treatment, i.e., may be included in the production method of the present embodiment separately from desmear treatment. Examples of the method for bringing the surface of the insulating layer into contact with an aqueous alkali solution in the alkali treatment step include a method involving spraying an aqueous alkali solution onto the surface of the insulating layer, a method involving immersing the surface of the insulating layer in an aqueous alkali solution, and a method involving coating the surface of the insulating layer with an aqueous alkali solution using a brush or a coater. Neither the contact time nor temperature is particularly limited as long as the problem is solved by the present invention. For example, the time may be 10 seconds to 60 minutes, and the temperature may be 10°C to 80°C.

The aqueous alkali solution used in the alkali treatment step is not particularly limited. Examples include aqueous solutions of sodium hydroxide, potassium hydroxide, sodium carbonate, ammonium, hydroxylamine, and tetramethylammonium hydroxide. Among these, an aqueous solution of sodium hydroxide and an aqueous solution of sodium carbonate are preferred in view of safety and cost. The pH of the aqueous alkali solution is not particularly limited, and

may be, for example, 8 to 13.

The conductor layer forming step is not particularly limited as long as it is the step of forming the conductor layer on at least a part of the surface, which has been brought into contact with the aqueous alkali solution, of the insulating layer. For example, the conductor layer may be formed, as with the outer layer circuit of a printed circuit board described below, on at least a part of the surface of the insulating layer that has undergone the alkali treatment step. Examples of the method for forming the conductor layer on the surface of the insulating layer include a method involving placing the insulating layer and the conductor layer one on top of the other and then pressing them in the laminating direction, a method involving electroless plating treatment to form the conductor layer on the surface of the insulating layer, and a method involving metal vapor deposition to form the conductor layer on the surface of the insulating layer. The conductor layer is preferably a layer formed by electroless plating treatment, in view of more effectively and reliably exhibiting the function effects of the present invention.

The material of the conductor layer is not particularly limited as long as it has conductivity. Examples include copper and aluminum. Among these, copper and aluminum are preferred, and copper is more preferred. These conductor layer materials are used singly or in combinations of two or more thereof. Also, the thickness of the conductor layer is not particularly limited, and may be, for example, 1 to 36 μm.

Specific examples of the method for producing a printed circuit board of the present embodiment include the following methods. First, the metal foil-clad laminate (copper-clad laminate, etc.) or laminate mentioned above is prepared. A metal foil or a support is separated from the metal foil-clad laminate or the laminate by etching or the like. Then, the exposed surface of the insulating layer, which is a cured product of the resin composition, may be brought into contact with an aqueous alkali solution. This contact treatment may be the alkali treatment step according to the present embodiment, or may be a treatment that also serves as desmear treatment. Furthermore, an inner layer circuit, which is a conductor layer, is formed on at least a part of the surface of the insulating layer to prepare an inner layer substrate. The formation of the inner layer circuit may be the conductor layer forming step according to the present embodiment, and in this case the inner layer circuit serves as the conductor layer.

Alternatively, the inner layer circuit surface is subjected, if necessary, to surface treatment for enhancing adhesion strength. Subsequently, a required number of the prepreg mentioned above is laminated on the resulting inner layer circuit surface. The resin composition layer is cured to obtain the insulating layer. Thereafter, the surface of the laminated and cured insulating layer may be brought into contact with an aqueous alkali solution. This contact treatment may be the alkali treatment step according to the present embodiment. Furthermore, a metal foil for an outer layer circuit is laterally laminated on the laminated and cured insulating layer, followed by integral molding under heat and pressure. This integral molding may be the conductor layer forming step according to the present embodiment, and in this case the metal foil serves as the conductor layer.

In this way, a multilayer laminate is produced in which the insulating layer composed of the base material and a cured product of resin composition is formed between the inner layer circuit and the metal foil for an outer layer circuit. Subsequently, this multilayer laminate is subjected to hole-making processing for making through-holes or via holes and then subjected to desmear treatment for removing smear, which is a residue of resins derived from the resin components contained in the cured product layer. This desmear treatment is preferably the alkali treatment step according to the present embodiment, in view of more effectively and reliably exhibiting the function effects of the present invention. Then, the inside walls of these holes are coated with a metal plating film for conducting the inner layer circuit and the metal foil for an outer layer circuit. In view of more effectively and reliably exhibiting the function effects of the present invention, this formation of a metal plating film (plating treatment) is preferably the conductor layer forming step according to the present embodiment, and in that case the metal plating film serves as the conductor layer. Furthermore, etching treatment is performed on the metal foil for an outer layer circuit to form an outer layer circuit, and a printed circuit board is thus produced.

When neither the metal foil-clad laminate nor the laminate is used, the printed circuit board may be prepared by curing the resin composition layer in the prepreg or the resin sheet to obtain the insulating layer and then forming the conductor layer, which serves as a circuit, on the insulating layer. In this case, an electroless plating approach may be used for forming the conductor layer. In this case as well, the conductor layer can be formed on at least a part of the surface of the insulating layer after the surface of the insulating layer undergoes the alkali treatment step of bringing the surface of the insulating layer brought into contact with an aqueous alkali solution.

The printed circuit board of the present embodiment can be particularly effectively used as a printed circuit board for semiconductor packages, because the insulating layer mentioned above maintains the excellent elastic modulus even at a reflow temperature during semiconductor packaging and thereby effectively suppresses the warpage of semiconductor plastic packages.

## Examples

Hereinafter, the present invention will be described in more detail with reference to Examples. However, the

present invention is not intended to be limited by these Examples.

(Synthesis Example 1) Synthesis of α-naphthol aralkyl-based cyanate ester resin

A reactor equipped with a thermometer, a stirrer, a dropping funnel, and a reflux condenser was cooled to 0 to 5°C in advance using brine and charged with 7.47 g (0.122 mol) of cyanogen chloride, 9.75 g (0.0935 mol) of 35% hydrochloric acid, 76 mL of water, and 44 mL of methylene chloride. While the temperature and pH of this reactor were kept at -5 to +5°C and 1 or lower, respectively, a solution containing 20 g (0.0935 mol) of an α-naphthol aralkyl-based phenol resin of the formula (9) wherein all of the $R_8$ were hydrogen atoms (SN485, OH group equivalent: 214 g/eq., softening point: 86°C, manufactured by Nippon Steel & Sumikin Chemical Co., Ltd.), and 14.16 g (0.14 mol) of triethylamine dissolved in 92 mL of methylene chloride was added dropwise over 1 hour through the dropping funnel with stirring. After the completion of the dropwise addition, 4.72 g (0.047 mol) of triethylamine was further added dropwise thereto over 15 minutes. After the completion of the dropwise addition, the mixture was stirred at the same temperature as above for 15 minutes. Then, the reaction solution was separated into organic and aqueous layers, and the organic layer was separated. The obtained organic layer was washed with 100 mL of water twice. Then, methylene chloride was distilled off under reduced pressure with an evaporator, and the residue was finally concentrated to dryness at 80°C for 1 hour to obtain 23.5 g of a cyanate ester product of the α-naphthol aralkyl-based phenol resin (α-naphthol aralkyl-based cyanate ester resin).

(Example 1)

[Preparation of prepreg]

10 parts by mass of the α-naphthol aralkyl-based cyanate ester resin obtained by Synthesis Example 1, 35 parts by mass of a novolac-based maleimide compound (BMI-2300, manufactured by Daiwa Fine Chemicals Co., Ltd.), 35 parts by mass of bisallylnadimide (BANI-M, manufactured by Maruzen Petrochemical Co., Ltd.), and 20 parts by mass of a biphenyl aralkyl-based epoxy resin (NC-3000FH, manufactured by Nippon Kayaku Co., Ltd.) were mixed with 100 parts by mass of spherical silica (SC-5050MOB, particle size: 1.6 μm, manufactured by Admatechs Co., Ltd.), 5 parts by mass of an acrylic silane compound 3-acryloxypropyltrimethoxysilane (KBM-5103, manufactured by Shin-Etsu Chemical Co., Ltd.), and 1 part by mass of a wetting dispersant (DISPERBYK-161, manufactured by BYK Japan K.K.), and the mixture was diluted with methyl ethyl ketone to obtain varnish. An E glass woven fabric was impregnated and coated with this varnish, and dried by heating at 160°C for 3 minutes to obtain a prepreg having a resin composition content of 49% by mass. In this respect, the ratio [β/α] was 1.54. In this context, the ratio [β/α] is represented by the following formula (the same holds true for the description below):

[β/α] = (Parts by mass of the maleimide compound / Functional group equivalent of the maleimide compound) / (Parts by mass of the alkenyl-substituted nadimide / Functional group equivalent of the alkenyl-substituted nadimide)

[Preparation of metal foil-clad laminate]

Electrolytic copper foils having a thickness of 3 μm (JXUT-I, manufactured by JX Nippon Mining & Metals Corporation, surface roughness Rz = 1.1 μm) were disposed on the upper and lower sides of 4 layers or 8 layers of the prepreg thus obtained, and laminate molding of the resultant was carried out at a pressure of 30 $kgf/cm^2$ and a temperature of 220°C for 120 minutes to obtain a copper-clad laminate having an insulating layer thickness of 0.4 mm or 0.8 mm as a metal foil-clad laminate.

[Production of printed circuit board]

The copper foil present on the surface layer of the copper-clad laminate having an insulating layer thickness of 0.4 mm obtained above was removed by etching, and the resulting insulating layer was immersed in an aqueous

alkali solution (1 N aqueous sodium hydroxide solution) at 40°C for 5 minutes. The insulating layer taken out from the aqueous alkali solution was washed with water and then subjected to an electroless copper plating process manufactured by C. Uyemura & Co., Ltd. (names of reagents used: MCD-PL, MDP-2, MAT-SP, MAB-4-C, and MEL-3-APEA ver. 2) to provide the surface of the insulating layer with about 0.5 $\mu$m of electroless copper plating, and drying was performed at 130°C for 1 hour. Subsequently, electrolytic copper plating was performed such that the plated copper had a thickness of 20 $\mu$m, and drying was performed at 180°C for 1 hour. Thus, a printed circuit board sample in which a conductor layer (plated copper) having a thickness of 20 $\mu$m was formed on an insulating layer having a thickness of 0.1 mm was prepared, and subjected to an evaluation for peeling of electroless plating (with alkali treatment). Also, a printed circuit board sample was prepared in which a conductor layer was formed by the above process except that the treatment with an aqueous alkali solution was not performed, and subjected to an evaluation for peeling of electroless plating (without alkali treatment).

(Example 2)

A metal foil-clad laminate as well as a printed circuit board were obtained in the same way as in Example 1 except that 2.5 parts by mass of an epoxysilane compound 3-glycidoxypropyltrimethoxysilane (KBM-403, manufactured by Shin-Etsu Chemical Co., Ltd.) and 2.5 parts by mass of an acrylic silane compound 3-acryloxypropyltrimethoxysilane (KBM-5103, manufactured by Shin-Etsu Chemical Co., Ltd.) were used instead of 5 parts by mass of an acrylic silane compound 3-acryloxypropyltrimethoxysilane (KBM-5103, manufactured by Shin-Etsu Chemical Co., Ltd.).

(Example 3)

A metal foil-clad laminate as well as a printed circuit board were obtained in the same way as in Example 1 except that 5 parts by mass of an acrylic silane compound methacryloxyoctyltrimethoxysilane (KBM-5803, manufactured by Shin-Etsu Chemical Co., Ltd.) was used instead of 5 parts by mass of an acrylic silane compound 3-acryloxypropyltrimethoxysilane (KBM-5103, manufactured by Shin-Etsu Chemical Co., Ltd.).

(Comparative Example 1)

A metal foil-clad laminate as well as a printed circuit board were obtained in the same way as in Example 1 except that 5 parts by mass of an epoxysilane compound 3-glycidoxypropyltrimethoxysilane (KBM-403, manufactured by Shin-Etsu Chemical Co., Ltd.) was used instead of 5 parts by mass of an acrylic silane compound 3-acryloxypropyltrimethoxysilane (KBM-5103, manufactured by Shin-Etsu Chemical Co., Ltd.).

(Comparative Example 2)

A metal foil-clad laminate as well as a printed circuit board were obtained in the same way as in Example 1 except that 2.5 parts by mass of an epoxysilane compound 3-glycidoxypropyltrimethoxysilane (KBM-403, manufactured by Shin-Etsu Chemical Co., Ltd.) and 2.5 parts by mass of a styryl silane compound p-styryltrimethoxysilane (KBM-1403, manufactured by Shin-Etsu Chemical Co., Ltd.) were used instead of 5 parts by mass of an acrylic silane compound 3-acryloxypropyltrimethoxysilane (KBM-5103, manufactured by Shin-Etsu Chemical Co., Ltd.).

(Comparative Example 3)

A metal foil-clad laminate as well as a printed circuit board were obtained in the same way as in Example 1 except that 5 parts by mass of a styryl silane compound p-styryltrimethoxysilane (KBM-1403, manufactured by Shin-Etsu Chemical Co., Ltd.) was used instead of 5 parts by mass of an acrylic silane compound 3-acryloxypropyltrimethoxysilane (KBM-5103, manufactured by Shin-Etsu Chemical Co., Ltd.).

[Chemical resistance]

The metal foil-clad laminate (50 mm $\times$ 50 mm $\times$ 0.8 mm) was dipped for 2 hours in an aqueous sodium hydroxide solution of 70°C adjusted to 1 N. The amount of decrease in weight (% by mass) was calculated from the masses of the metal foil-clad laminate before and after the dipping. A lower absolute value means better chemical resistance (alkali resistance). The results are shown in Table 1.

[Desmear resistance]

The copper foils were removed from both sides of the metal foil-clad laminate (50 mm × 50 mm × 0.8 mm) by etching. The resulting sample was dipped in Swelling Dip Securiganth P manufactured by Atotech Japan K.K. as a swelling solution at 80°C for 10 minutes, then dipped in Concentrate Compact CP manufactured by Atotech Japan K.K. as a roughening solution at 80°C for 5 minutes, and finally dipped in Reduction Conditioner Securiganth P500 manufactured by Atotech Japan K.K. as a neutralizing solution at 45°C for 10 minutes. This treatment was repetitively carried out three times. Then, the amount of decrease in mass (% by mass) was determined from the masses of the metal foil-clad laminate before and after the treatment. A lower absolute value means better desmear resistance. The results are shown in Table 1.

[Peeling of electroless plating]

Using printed wiring board samples having an insulating layer thickness of 0.4 mm prepared by the above process, the adhesion of plated copper was measured 3 times in accordance with JIS C 6481 and taken an average.

[Table 1]

| | | Example 1 | Example 2 | Example 3 | Comparative Example 1 | Comparative Example 2 | Comparative Example 3 |
|---|---|---|---|---|---|---|---|
| Peeling of electroless plating (without alkali treatment) | kg/N | 0.43 | 0.47 | 0.40 | 0.50 | 0.45 | 0.37 |
| Peeling of electroless plating (with alkali treatment) | kg/N | 0.65 | 0.59 | 0.62 | 0.47 | 0.45 | 0.34 |
| Chemical resistance | % by mass | -1.23 | -1.17 | -1.34 | -1.34 | -0.77 | -0.83 |
| Desmear resistance | % by mass | -1.48 | -0.71 | -1.72 | -0.63 | -0.45 | -0.59 |

The present application is based on Japanese Patent Application No. 2015-135203 filed on July 6, 2015, the contents of which are incorporated herein by reference.

Industrial Applicability

The present invention can provide a printed circuit board capable of enhancing the adhesion between an insulating layer containing an inorganic filler and a conductor layer, and is therefore industrially applicable to fields such as printed circuit boards for use in semiconductor plastic packages.

## Claims

**1.** A method for producing a printed circuit board, comprising:

an alkali treatment step of bringing a surface of an insulating layer for a printed circuit board into contact with an aqueous alkali solution, and
a conductor layer forming step of forming a conductor layer on at least a part of the surface of the insulating layer that has undergone the alkali treatment step, wherein
the insulating layer comprises a resin composition comprising a thermosetting resin, a silane compound having a (meth)acrylic skeleton and a hydrolyzable group or a hydroxy group, and an inorganic filler.

**2.** The production method according to claim 1, wherein the resin composition comprises a maleimide compound as the thermosetting resin.

3. The production method according to claim 2, wherein the resin composition comprises, as the maleimide compound, at least one compound selected from the group consisting of bis(4-maleimidophenyl)methane, 2,2-bis{4-(4-maleimidophenoxy)-phenyl}propane, bis(3-ethyl-5-methyl-4-maleimidophenyl)methane, and a maleimide compound represented by the following formula (6):

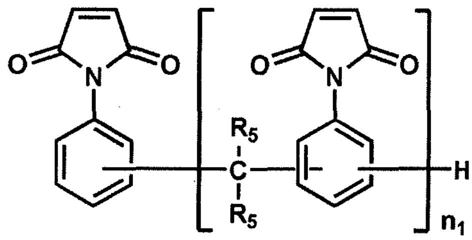

(6)

wherein each $R_5$ independently represents a hydrogen atom or a methyl group, and $n_1$ represents an integer of 1 or larger.

4. The production method according to any one of claims 1 to 3, wherein the resin composition comprises an alkenyl-substituted nadimide as the thermosetting resin.

5. The production method according to claim 4, wherein the resin composition comprises, as the alkenyl-substituted nadimide, a compound represented by the following formula (1):

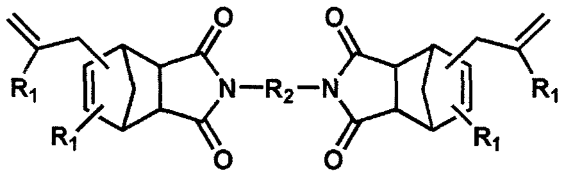

(1)

wherein each $R_1$ independently represents a hydrogen atom or an alkyl group having 1 to 6 carbon atoms, and $R_2$ represents an alkylene group having 1 to 6 carbon atoms, a phenylene group, a biphenylene group, a naphthylene group, or a group represented by the following formula (2) or (3) :

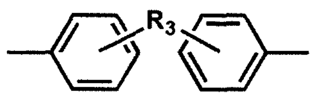

(2)

wherein $R_3$ represents a methylene group, an isopropylidene group, or a substituent represented by CO, O, S, or $SO_2$, and

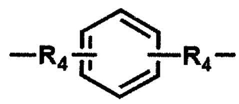

(3)

wherein each $R_4$ independently represents an alkylene group having 1 to 4 carbon atoms, or a cycloalkylene group having 5 to 8 carbon atoms.

6. The production method according to claim 4 or 5, wherein the resin composition comprises, as the alkenyl-substituted nadimide, a compound represented by the following formula (4) and/or (5):

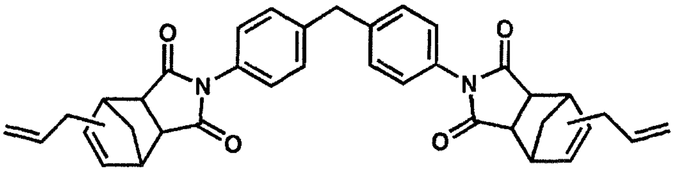

(4)

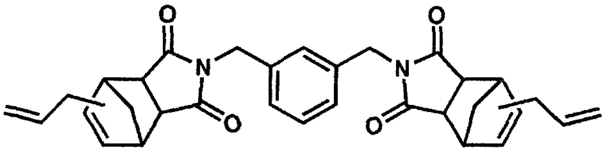

(5)

7. The production method according to any one of claims 1 to 6, wherein the resin composition comprises, as the silane compound having a (meth)acrylic skeleton and a hydrolyzable group or a hydroxy group, a compound represented by the following formula (C):

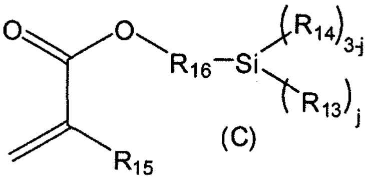

(C)

wherein $R_{13}$ represents a hydrolyzable group or a hydroxy group; $R_{14}$ represents a hydrogen atom or an alkyl group having 1 to 3 carbon atoms; when a plurality of $R_{13}$ or $R_{14}$ are present, the plurality of $R_{13}$ or $R_{14}$ are the same as or different from each other; $R_{15}$ represents a hydrogen atom or a methyl group; $R_{16}$ represents an alkylene group having 2 to 10 carbon atoms; and j represents an integer of 1 to 3.

8. The production method according to any one of claims 1 to 7, wherein the resin composition further comprises one or more compounds selected from the group consisting of a silane compound having a styrene skeleton and a hydrolyzable group or a hydroxy group, a silane compound having an epoxy skeleton and a hydrolyzable group or a hydroxy group, an aminosilane compound having an amino group and a hydrolyzable group or a hydroxy group, and a vinylsilane compound having a vinyl group and a hydrolyzable group or a hydroxy group.

9. The production method according to any one of claims 1 to 7, wherein the resin composition further comprises a silane compound having an epoxy skeleton and a hydrolyzable group or a hydroxy group.

10. The production method according to claim 8 or 9, wherein the resin composition comprises, as the silane compound having an epoxy skeleton and a hydrolyzable group or a hydroxy group, a compound represented by the following formula (D):

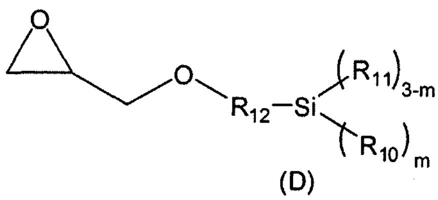

(D)

wherein $R_{10}$ represents a hydrolyzable group or a hydroxy group; $R_{11}$ represents a hydrogen atom or an alkyl group having 1 to 3 carbon atoms; when a plurality of $R_{10}$ or $R_{11}$ are present, the plurality of $R_{10}$ or $R_{11}$ are the same as or different from each other; $R_{12}$ represents an alkylene group having 1 to 10 carbon atoms; and m represents an integer of 1 to 3.

11. The production method according to any one of claims 1 to 10, wherein the resin composition further comprises a cyanate ester compound.

**12.** The production method according to claim 11, wherein the resin composition comprises, as the cyanate ester compound, a compound represented by the following formula (7) and/or (8):

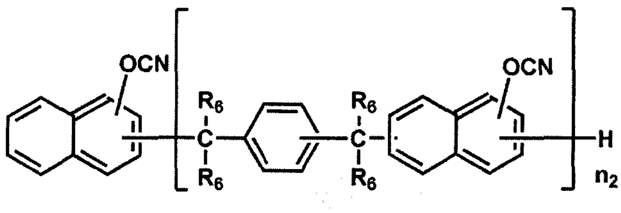

(7)

wherein each $R_6$ independently represents a hydrogen atom or a methyl group, and $n_2$ represents an integer of 1 or larger, and

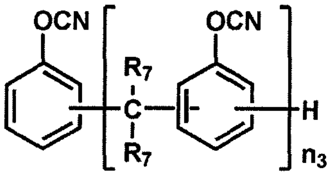

(8)

wherein each $R_7$ independently represents a hydrogen atom or a methyl group, and $n_3$ represents an integer of 1 or larger.

**13.** The production method according to any one of claims 1 to 12, wherein the inorganic filler is one or more selected from the group consisting of silica, alumina, and boehmite.

**14.** The production method according to any one of claims 1 to 13, wherein the insulating layer is obtained from a prepreg in which a base material is impregnated or coated with the resin composition.

**15.** The production method according to claim 14, wherein the base material is at least one material selected from the group consisting of E glass cloth, T glass cloth, S glass cloth, Q glass cloth, and an organic fiber cloth.

**16.** The production method according to any one of claims 1 to 13, wherein the insulating layer is obtained from a resin sheet in which a support is coated with the resin composition.

**17.** The production method according to any one of claims 1 to 13, wherein the insulating layer is obtained from a laminate obtained in such a way that one or more layers of at least one selected from the group consisting of a prepreg in which a base material is impregnated or coated with the resin composition and a resin sheet in which a support is coated with the resin composition are laminated and cured.

**18.** The production method according to any one of claims 1 to 13, wherein the insulating layer is obtained from a metal-clad laminate obtained in such a way that at least one selected from the group consisting of a prepreg in which a base material is impregnated or coated with the resin composition and a resin sheet in which a support is coated with the resin composition and a metal foil are laminated and cured.

**19.** The production method according to any one of claims 1 to 18, wherein the conductor layer is a layer formed by plating treatment.

**Patentansprüche**

**1.** Verfahren zur Herstellung einer gedruckten Leiterplatte, umfassend:

einen Alkalibehandlungsschritt zum Inkontaktbringen einer Oberfläche einer Isolierschicht für eine gedruckte Leiterplatte mit einer wässrigen Alkalilösung und
einen Leiterschichtbildungsschritt zur Bildung einer Leiterschicht auf mindestens einem Teil der Oberfläche der

Isolierschicht, die dem Alkalibehandlungsschritt unterzogen wurde, wobei die Isolierschicht eine Harzzusammensetzung umfasst, die ein wärmehärtendes Harz, eine Silanverbindung mit einem (Meth)acrylgerüst und einer hydrolysierbaren Gruppe oder einer Hydroxygruppe und einen anorganischen Füllstoff umfasst.

**2.** Herstellungsverfahren gemäß Anspruch 1, wobei die Harzzusammensetzung eine Maleimidverbindung als das wärmehärtende Harz umfasst.

**3.** Herstellungsverfahren gemäß Anspruch 2, wobei die Harzzusammensetzung als die Maleimidverbindung mindestens eine Verbindung, ausgewählt aus der Gruppe, bestehend aus Bis(4-maleimidophenyl)methan, 2,2-Bis{4-(4-maleimidophenoxy)-phenyl}propan, Bis(3-ethyl-5-methyl-4-maleimidophenyl)methan und einer durch die folgende Formel (6) dargestellten Maleimidverbindung, umfasst:

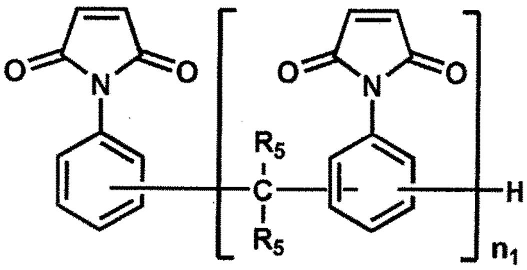
(6)

wobei jedes $R_5$ unabhängig ein Wasserstoffatom oder eine Methylgruppe darstellt und $n_1$ eine ganze Zahl von 1 oder größer darstellt.

**4.** Herstellungsverfahren gemäß irgendeinem der Ansprüche 1 bis 3, wobei die Harzzusammensetzung ein Alkenylsubstituiertes Nadimid als das wärmehärtende Harz umfasst.

**5.** Herstellungsverfahren gemäß Anspruch 4, wobei die Harzzusammensetzung als das Alkenyl-substituierte Nadimid eine durch die folgende Formel (1) dargestellte Verbindung umfasst:

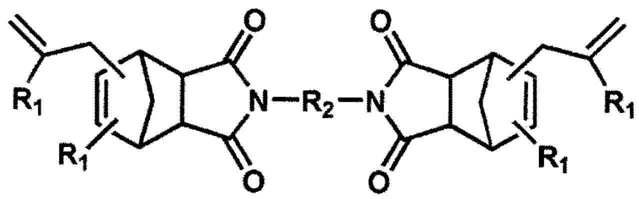
(1)

worin jedes $R_1$ unabhängig ein Wasserstoffatom oder eine Alkylgruppe mit 1 bis 6 Kohlenstoffatomen darstellt und $R_2$ eine Alkylengruppe mit 1 bis 6 Kohlenstoffatomen, eine Phenylengruppe, eine Biphenylengruppe, eine Naphthylengruppe oder eine durch die folgende Formel (2) oder (3) dargestellte Gruppe darstellt:

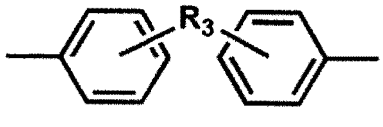
(2)

worin $R_3$ eine Methylengruppe, eine Isopropylidengruppe oder einen Substituenten, dargestellt durch CO, O, S oder $SO_2$, darstellt, und

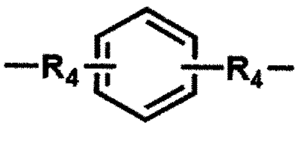
(3)

worin jedes $R_4$ unabhängig eine Alkylengruppe mit 1 bis 4 Kohlenstoffatomen oder eine Cycloalkylengruppe mit 5 bis 8 Kohlenstoffatomen darstellt.

6. Herstellungsverfahren gemäß Anspruch 4 oder 5, wobei die Harzzusammensetzung als das Alkenyl-substituierte Nadimid eine durch die folgende Formel (4) und/oder (5) dargestellte Verbindung umfasst:

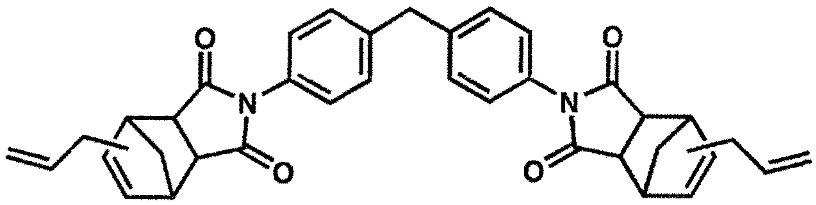
(4)

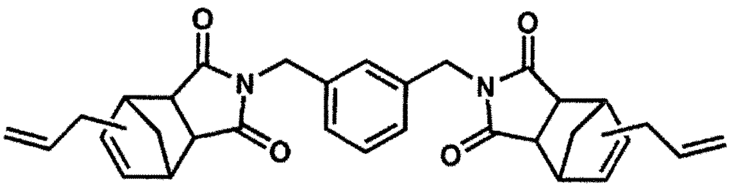
(5)

7. Herstellungsverfahren gemäß irgendeinem der Ansprüche 1 bis 6, wobei die Harzzusammensetzung als die Silanverbindung mit einem (Meth)acrylgerüst und einer hydrolysierbaren Gruppe oder einer Hydroxygruppe eine durch die folgende Formel (C) dargestellte Verbindung umfasst:

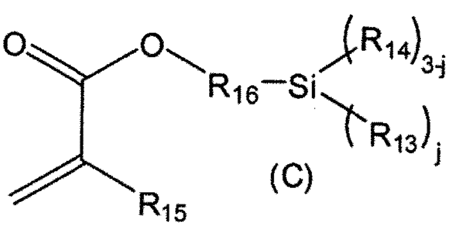
(C)

worin $R_{13}$ eine hydrolysierbare Gruppe oder eine Hydroxygruppe darstellt, $R_{14}$ ein Wasserstoffatom oder eine Alkylgruppe mit 1 bis 3 Kohlenstoffatomen darstellt, wenn mehrere $R_{13}$ oder $R_{14}$ vorhanden sind, die mehreren $R_{13}$ oder $R_{14}$ dieselben oder verschieden voneinander sind, $R_{15}$ ein Wasserstoffatom oder eine Methylgruppe darstellt, $R_{16}$ eine Alkylengruppe mit 2 bis 10 Kohlenstoffatomen darstellt und j eine ganze Zahl von 1 bis 3 darstellt.

8. Herstellungsverfahren gemäß irgendeinem der Ansprüche 1 bis 7, wobei die Harzzusammensetzung ferner eine oder mehrere Verbindungen, ausgewählt aus der Gruppe, bestehend aus einer Silanverbindung mit einem Styrolgerüst und einer hydrolysierbaren Gruppe oder einer Hydroxygruppe, einer Silanverbindung mit einem Epoxygerüst und einer hydrolysierbaren Gruppe oder einer Hydroxygruppe, einer Aminoslianverbindung mit einer Aminogruppe und einer hydrolysierbaren Gruppe oder einer Hydroxygruppe und einer Vinylsilanverbindung mit einer Vinylgruppe und einer hydrolysierbaren Gruppe oder einer Hydroxygruppe, umfasst.

9. Herstellungsverfahren gemäß irgendeinem der Ansprüche 1 bis 7, wobei die Harzzusammensetzung ferner eine Silanverbindung mit einem Epoxygerüst und einer hydrolysierbaren Gruppe oder einer Hydroxygruppe umfasst.

10. Herstellungsverfahren gemäß Anspruch 8 oder 9, wobei die Harzzusammensetzung als die Silanverbindung mit einem Epoxygerüst und einer hydrolysierbaren Gruppe oder einer Hydroxygruppe eine durch die folgende Formel (D) dargestellte Verbindung umfasst:

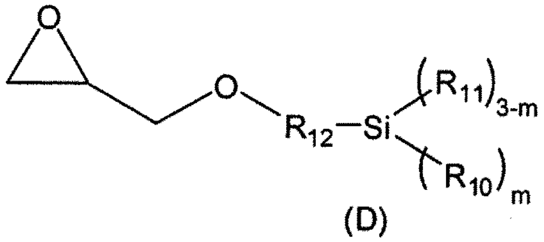

(D)

worin $R_{10}$ eine hydrolysierbare Gruppe oder eine Hydroxygruppe darstellt, $R_{11}$ ein Wasserstoffatom oder eine Alkylgruppe mit 1 bis 3 Kohlenstoffatomen darstellt, wenn mehrere $R_{10}$ oder $R_{11}$ vorhanden sind, die mehreren $R_{10}$ oder $R_{11}$ gleich oder verschieden voneinander sind, $R_{12}$ eine Alkylengruppe mit 1 bis 10 Kohlenstoffatomen darstellt und m eine ganze Zahl von 1 bis 3 darstellt.

**11.** Herstellungsverfahren gemäß irgendeinem der Ansprüche 1 bis 10, wobei die Harzzusammensetzung ferner eine Cyanatesterverbindung umfasst.

**12.** Herstellungsverfahren gemäß Anspruch 11, wobei die Harzzusammensetzung als die Cyanatesterverbindung eine durch die folgende Formel (7) und/oder (8) dargestellte Verbindung umfasst:

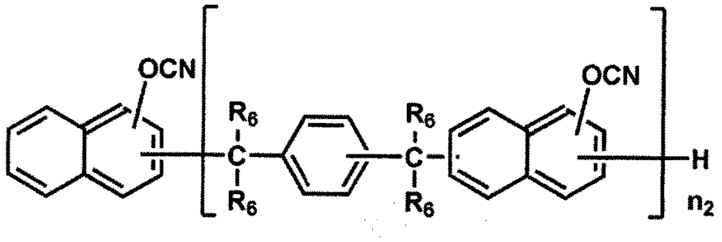

(7)

worin jedes $R_6$ unabhängig ein Wasserstoffatom oder einer Methylgruppe darstellt und $n_2$ eine ganze Zahl von 1 oder größer darstellt, und

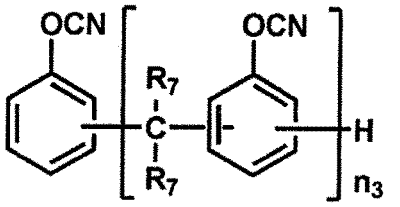

(8)

worin jedes $R_7$ unabhängig ein Wasserstoffatom oder eine Methylgruppe darstellt und $n_3$ eine ganze Zahl von 1 oder größer darstellt.

**13.** Herstellungsverfahren gemäß irgendeinem der Ansprüche 1 bis 12, wobei der anorganische Füllstoff eines oder mehrere, ausgewählt aus der Gruppe, bestehend aus Siliciumoxid, Aluminiumoxid und Böhmit, ist.

**14.** Herstellungsverfahren gemäß irgendeinem der Ansprüche 1 bis 13, wobei die Isolierschicht aus einem Prepreg erhalten wird, in dem ein Basismaterial mit der Harzzusammensetzung imprägniert oder beschichtet ist.

**15.** Herstellungsverfahren gemäß Anspruch 14, wobei das Basismaterial mindestens ein Material, ausgewählt aus der Gruppe, bestehend aus E-Glasgewebe, T-Glasgewebe, S-Glasgewebe, Q-Glasgewebe und einem organischen Fasergewebe, ist.

**16.** Herstellungsverfahren gemäß irgendeinem der Ansprüche 1 bis 13, wobei die Isolierschicht aus einer Harzfolie erhalten wird, in der ein Träger mit der Harzzusammensetzung beschichtet ist.

**17.** Herstellungsverfahren gemäß irgendeinem der Ansprüche 1 bis 13, wobei die Isolierschicht aus einem Laminat erhalten wird, das so erhalten wird, dass eine oder mehrere Schichten aus mindestens einem, ausgewählt aus der

Gruppe, bestehend aus einem Prepreg, in dem ein Basismaterial mit der Harzzusammensetzung imprägniert oder beschichtet ist, und einer Harzfolie, in der ein Träger mit der Harzzusammensetzung beschichtet ist, laminiert und gehärtet werden.

**18.** Herstellungsverfahren gemäß irgendeinem der Ansprüche 1 bis 13, wobei die Isolierschicht aus einem metallkaschierten Laminat erhalten wird, das so erhalten wird, dass mindestens eines, ausgewählt aus der Gruppe, bestehend aus einem Prepreg, in dem ein Basismaterial mit der Harzzusammensetzung imprägniert oder beschichtet ist, und einer Harzfolie, in der ein Träger mit der Harzzusammensetzung beschichtet ist, und eine Metallfolie laminiert und gehärtet werden.

**19.** Herstellungsverfahren gemäß irgendeinem der Ansprüche 1 bis 18, wobei die Leiterschicht eine Schicht ist, die durch eine Plattierungsbehandlung gebildet wird.

## Revendications

**1.** Procédé de production d'une carte à circuits imprimés, comprenant :

une étape de traitement alcalin consistant à mettre une surface d'une couche isolante destinée à une carte à circuits imprimés en contact avec une solution aqueuse alcaline, et
une étape de formation d'une couche conductrice consistant à former une couche conductrice sur au moins une partie de la surface de la couche isolante qui a subi l'étape de traitement alcalin, dans lequel
la couche isolante comprend une composition de résine comprenant une résine thermodurcissable, un composé silane possédant un squelette (méth)acrylique et un groupe hydrolysable ou un groupe hydroxyle, et une charge inorganique.

**2.** Procédé de production selon la revendication 1, dans lequel la composition de résine comprend un composé maléimide au titre de la résine thermodurcissable.

**3.** Procédé de production selon la revendication 2, dans lequel la composition de résine comprend, au titre du composé maléimide, au moins un composé choisi dans le groupe constitué par le bis(4-maléimidophényl)méthane, le 2,2-bis{4-(4-maléimidophénoxy)-phényl}propane, le bis(3-éthyle-5-méthyle-4-maléimidophényl)méthane et un composé maléimide représenté par la formule suivante (6) :

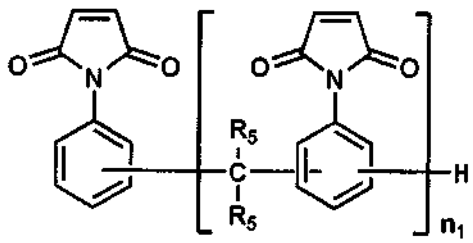
(6)

dans laquelle chaque $R_5$ représente indépendamment un atome d'hydrogène ou un groupe méthyle, et $n_1$ représente un entier supérieur ou égal à 1.

**4.** Procédé de production selon l'une quelconque des revendications 1 à 3, dans lequel la composition de résine comprend un nadimide à substitution alcényle au titre de la résine thermodurcissable.

**5.** Procédé de production selon la revendication 4, dans lequel la composition de résine comprend, au titre du nadimide à substitution alcényle, un composé représenté par la formule suivante (1) :

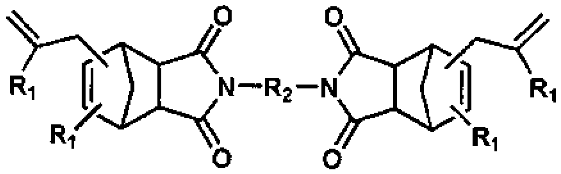
(1)

dans laquelle chaque $R_1$ représente indépendamment un atome d'hydrogène ou un groupe alkyle présentant de 1 à 6 atomes de carbone, et $R_2$ représente un groupe alkylène présentant de 1 à 6 atomes de carbone, un groupe phénylène, un groupe biphénylène, un groupe naphthylène, ou un groupe représenté par la formule suivante (2) ou (3) :

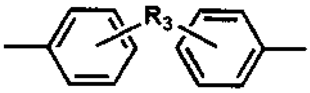
(2)

dans laquelle $R_3$ représente un groupe méthylène, un groupe isopropylidène, ou un substituant représenté par CO, O, S, ou $SO_2$, et

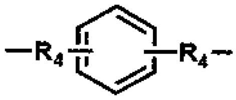
(3)

dans laquelle chaque $R_4$ représente indépendamment un groupe alkylène présentant de 1 à 4 atomes de carbone, ou un groupe cyclo-alkylène présentant de 5 à 8 atomes de carbone.

**6.** Procédé de production selon la revendication 4 ou 5, dans lequel la composition de résine comprend, au titre du nadimide à substitution alcényle, un composé représenté par la formule suivante (4) et/ou (5) :

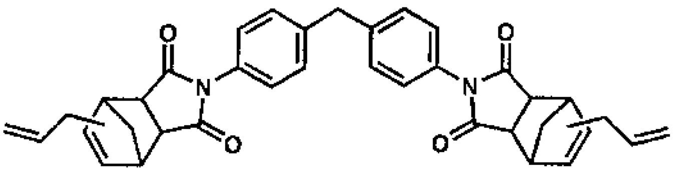
(4)

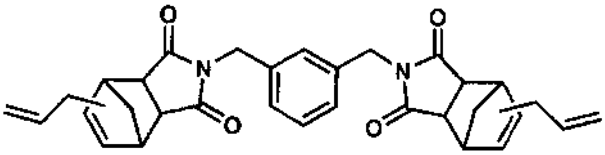
(5)

**7.** Procédé de production selon l'une quelconque des revendications 1 à 6, dans lequel la composition de résine comprend, au titre du composé silane possédant un squelette (méth)acrylique et un groupe hydrolysable ou un groupe hydroxyle, un composé représenté par la formule suivante (C) :

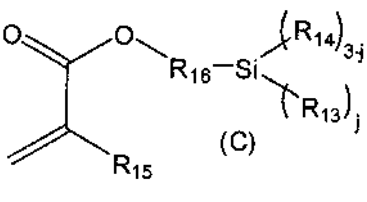
(C)

dans laquelle $R_{13}$ représente un groupe hydrolysable ou un groupe hydroxyle ; $R_{14}$ représente un atome d'hydrogène ou un groupe alkyle présentant de 1 à 3 atomes de carbone ; lorsqu'il existe une pluralité de $R_{13}$ ou de $R_{14}$, la pluralité de $R_{13}$ ou de $R_{14}$ sont identiques ou différents entre eux ; $R_{15}$ représente un atome d'hydrogène ou un groupe méthyle ; $R_{16}$ représente un groupe alkylène présentant de 2 à 10 atomes de carbone ; et j représente un entier compris de 1 à 3.

**8.** Procédé de production selon l'une quelconque des revendications 1 à 7, dans lequel la composition de résine comprend en outre un ou plusieurs composés choisis dans le groupe constitué par un composé silane possédant un squelette styrène et un groupe hydrolysable ou un groupe hydroxyle, un composé silane possédant un squelette

époxy et un groupe hydrolysable ou un groupe hydroxyle, un composé aminosilane possédant un groupe amino et un groupe hydrolysable ou un groupe hydroxyle, et un composé vinylsilane possédant un groupe vinyle et un groupe hydrolysable ou un groupe hydroxyle.

**9.** Procédé de production selon l'une quelconque des revendications 1 à 7, dans lequel la composition de résine comprend en outre un composé silane possédant un squelette époxy et un groupe hydrolysable ou un groupe hydroxyle.

**10.** Procédé de production selon la revendication 8 ou 9, dans lequel la composition de résine comprend, au titre du composé silane possédant un squelette époxy et un groupe hydrolysable ou un groupe hydroxyle, un composé représenté par la formule suivante (D) :

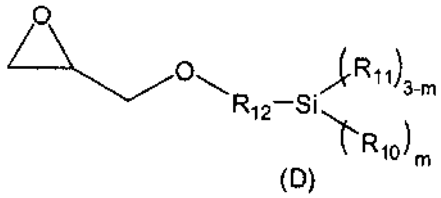

(D)

dans laquelle $R_{10}$ représente un groupe hydrolysable ou un groupe hydroxyle ; $R_{11}$ représente un atome d'hydrogène ou un groupe alkyle présentant de 1 à 3 atomes de carbone ; lorsqu'il existe une pluralité de $R_{10}$ ou de $R_{11}$, la pluralité de $R_{10}$ ou de $R_{11}$ sont identiques ou différents entre eux ; $R_{12}$ représente un groupe alkylène présentant de 1 à 10 atomes de carbone ; et m représente un entier compris de 1 à 3.

**11.** Procédé de production selon l'une quelconque des revendications 1 à 10, dans lequel la composition de résine comprend en outre un composé ester de cyanate.

**12.** Procédé de production selon la revendication 11, dans lequel la composition de résine comprend, au titre du composé ester de cyanate, un composé représenté par la formule suivante (7) et/ou (8) :

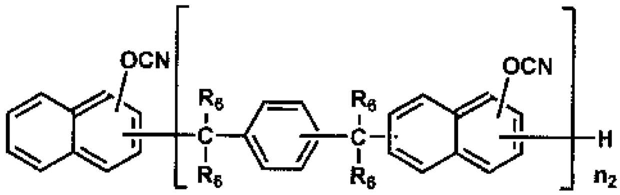

(7)

dans laquelle chaque $R_6$ représente indépendamment un atome d'hydrogène ou un groupe méthyle et $n_2$ représente un entier supérieur ou égal à 1, et

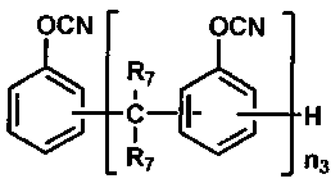

(8)

dans laquelle chaque $R_7$ représente indépendamment un atome d'hydrogène ou un groupe méthyle et $n_3$ représente un entier supérieur ou égal à 1.

**13.** Procédé de production selon l'une quelconque des revendications 1 à 12, dans lequel la charge inorganique est un ou plusieurs éléments choisis dans le groupe constitué par la silice, l'alumine et la boehmite.

**14.** Procédé de production selon l'une quelconque des revendications 1 à 13, dans lequel la couche isolante est obtenue à partir d'un pré-imprégné dans lequel un matériau de base est imprégné ou recouvert de la composition de résine.

**15.** Procédé de production selon la revendication 14, dans lequel le matériau de base est au moins un matériau choisi dans le groupe constitué par un tissu de verre E, un tissu de verre T, un tissu de verre S, un tissu de verre Q, et un tissu de fibres inorganiques.

**16.** Procédé de production selon l'une quelconque des revendications 1 à 13, dans lequel la couche isolante est obtenue à partir d'une feuille de résine dans laquelle un support est recouvert de la composition de résine.

**17.** Procédé de production selon l'une quelconque des revendications 1 à 13, dans lequel la couche isolante est obtenue à partir d'un stratifié obtenu de telle manière qu'une ou plusieurs couches d'au moins un élément choisi dans le groupe constitué par un pré-imprégné dans lequel un matériau de base est imprégné ou recouvert de la composition de résine et une feuille de résine dans laquelle un support est recouvert de la composition de résine soient stratifiées et durcies.

**18.** Procédé de production selon l'une quelconque des revendications 1 à 13, dans lequel la couche isolante est obtenue à partir d'un stratifié métallisé obtenu de telle manière qu'au moins un élément choisi dans le groupe constitué par un pré-imprégné dans lequel un matériau de base est imprégné ou recouvert de la composition de résine et une feuille de résine dans laquelle un support est recouvert de la composition de résine et d'une feuille métallique soit stratifié et durci.

**19.** Procédé de production selon l'une quelconque des revendications 1 à 18, dans lequel la couche conductrice est une couche formée au moyen d'un traitement de placage.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- EP 2733177 A1
- JP 2013216884 A
- JP 3173332 B
- JP 2009035728 A
- JP 2013001807 A
- JP 2011178992 A
- JP 2015135203 A